# EUROPÄISCHE PATENTSCHRIFT

(11) **EP 1 638 206 B1**
(45) Veröffentlichungstag und Bekanntmachung des Hinweises auf die Patenterteilung: **13.12.2017**
(21) Anmeldenummer: 05019185.7
(22) Anmeldetag: 03.09.2005
(51) Int. Cl.: H03K 17/95, H03K 17/965

(54) **Positionsüberwachungseinrichtung**
Position monitoring device
Dispositif de surveillance de position

(30) Priorität: 20.09.2004 DE 102004045909; 05.10.2004 DE 102004049024
(43) Veröffentlichungstag der Anmeldung: 22.03.2006
(73) Patentinhaber: K.A. Schmersal Holding KG, 42279 Wuppertal (DE)
(72) Erfinder: Stratmann, Christoph, 45277 Essen (DE); Hoepken, Hermann, 45549 Sprockhövel (DE)
(74) Vertreter: Sparing Röhl Henseler

(56) Entgegenhaltungen:
- DE-A1- 10 230 564
- DE-A1- 10 348 884
- DE-A1- 19 711 588
- DE-C1- 19 928 641
- GB-A- 1 452 132
- GB-A- 2 354 557
- JP-A- 1 191 510
- JP-A- 2001 018 748

## Beschreibung

Die Erfindung betrifft eine Positionsüberwachungseinrichtung.

Bekannte Positionsschalter, vgl. beispielsweise DE 199 53 898 A1, DE 199 28 641 C1, DE 197 11 588 A1, DE 102 30 564 A1 oder EP 0 987 726 A2, dienen insbesondere der Überwachung der Schließstellung von Zugangsschutzeinrichtungen für Maschinen oder maschinelle Anlagen mit Gefahrpotential, beispielsweise einer Klappe in der Verkleidung einer Fleischwürfelmaschine oder einer Zugangstür einer Umzäunung eines Abschnitts einer Verarbeitungsroboter aufweisenden Produktionsstraße. Typischerweise wird die Maschine oder maschinelle Anlage beim Öffnen der Zugangsschutzeinrichtung abgeschaltet und ein erneutes Einschalten verhindert, bis die Zugangsschutzeinrichtung wieder geschlossen ist. Hierzu ist an einem schließenden Teil der Zugangsschutzeinrichtung, z.B. der Klappe oder Tür, ein Transponder angebracht, der von einem Sendeempfänger an einem verschließbaren Teil, z.B. der Verkleidung oder Umzäunung, erkennbar ist, wenn der Abstand zwischen Transponder und Sendeempfänger einen Schließstellungsgrenzabstand unterschreitet. Dabei ist durch exakte Montage des Transponders und Sendeempfängers sicherzustellen, daß der Schließstellungsgrenzabstand nur bei vollständig geschlossener Zugangsschutzeinrichtung unterschritten wird. Eine gegebenenfalls erforderliche Justage nach der Montage erfordert einen Versatz des Transponders und/oder des Sendeempfängers. Zudem ist es bei beengten Platzverhältnissen nicht immer möglich, Sendeempfänger und Transponder im erforderlichen Abstand zueinander zu montieren. Dies kann dazu führen, daß bei leicht geöffneter Stellung der Zugangsschutzeinrichtung eine geschlossene Schließstellung signalisiert und die Maschine nicht abgeschaltet wird.

Aus JP2001018748A ist eine Vorrichtung zur Feststellung, ob ein Rastelement eines Sitzgurtes in die Verrasteinrichtung eingeführt ist, für ein Kraftfahrzeug bekannt. Hierbei wird ein digitales Ergebnis ermittelt. Mit der Vorrichtung ist feststellbar, ob der Gurt geschlossen ist oder nicht. Eine Abschirmung ist nicht einstellbar, so dass auch ein Stellungsgrenzabstand zwischen einem ersten und einem zweiten Teil nicht einstellbar ist. Der Erfindung liegt daher die Aufgabe zugrunde, eine Positionsüberwachungseinrichtung zu schaffen, die sicherer ist.

Diese Aufgabe wird entsprechend den Merkmalen des Anspruchs 1 gelöst.

Bei einer Positionsüberwachungseinrichtung zum Feststellen der Stellung eines ersten Teils gegenüber einem zweiten Teil, die einen Sendeempfänger am ersten Teil zum Aussenden eines Abfragesignals und zum Empfangen eines in Reaktion auf das Abfragesignal von einem Transponder aussendbaren, vorzugsweise eindeutig kodierten Antwortsignals aufweist, ist daher eine Signale zwischen dem Transponder und dem Sendeempfänger dämpfende Abschirmung vorgesehen, wobei zwei der Teile Sendempfänger, Abschirmung und Transponder relativ zueinander beweglich sind. Hierdurch läßt sich eine sichere positionsmäßige Zuordnung des jeweils relativ zum anderen beweglichen Teils erreichen, da keine bestimmte, genau justierte Positionierung erforderlich wird. Dadurch, daß die zwischen Stellungen mit jeweils unterschiedlicher Abschirmstärke für den Transponder oder den Sendeempfänger verstellbare Abschirmung Signale zwischen dem Transponder und dem Sendeempfänger dämpfen kann, kann der Stellungsgrenzabstand, d.h. der Grenzabstand zwischen einer ersten und einer zweiten Stellung zweier relativ zueinander beweglicher Teile, auf einfache Weise zwischen Null und einem durch die Sende/Empfangsleistung vorgegebenen Höchstwert eingestellt werden. Neben der erhöhten Sicherheit infolge genauer Einstellbarkeit des Stellungsgrenzabstands ergibt sich auch eine Vereinfachung der Montage des Transponders und des Sendeempfängers, da auf einen bestimmten Abstand nicht geachtet werden muß.

Die Positionsüberwachungseinrichtung kann zweckmäßigerweise in Form eines Positionsschalters ausgebildet sein und eignet sich für die Überwachung der Schließstellung einer Zugangsschutzeinrichtung oder allgemein zur Überwachung, ob ein erstes Teil benachbart zu einem zweiten Teil ist oder nicht, beispielsweise ein erstes Teil gegenüber einem zweiten ein- bzw. ausgefahren ist, und insbesondere zum Feststellen der Schließstellung eines verschließenden Teils gegenüber einem verschließbaren Teil einer Zugangsschutzeinrichtung für eine Maschine oder maschinelle Anlage mit Gefahrpotential,

Weitere Ausgestaltungen der Erfindung sind der nachfolgenden Beschreibung und den Unteransprüchen zu entnehmen.

Die Erfindung wird nachstehend anhand von in den beigefügten Abbildungen dargestellten Ausführungsbeispielen näher erläutert.
Fig. 1 zeigt schematisch ein erstes Ausführungsbeispiel einer Einrichtung zum Feststellen der Stellung eines Teils gegenüber einem anderen in Form eines Positionsschalters.
Fig. 2 zeigt schematisch ein zweites Ausführungsbeispiel einer Einrichtung zum Feststellen der Stellung eines Teils gegenüber einem anderen in Form eines Positionsschalters.
Fig. 3 zeigt schematisch ein drittes Ausführungsbeispiel einer Einrichtung zum Feststellen der Stellung eines Teils gegenüber einem anderen.

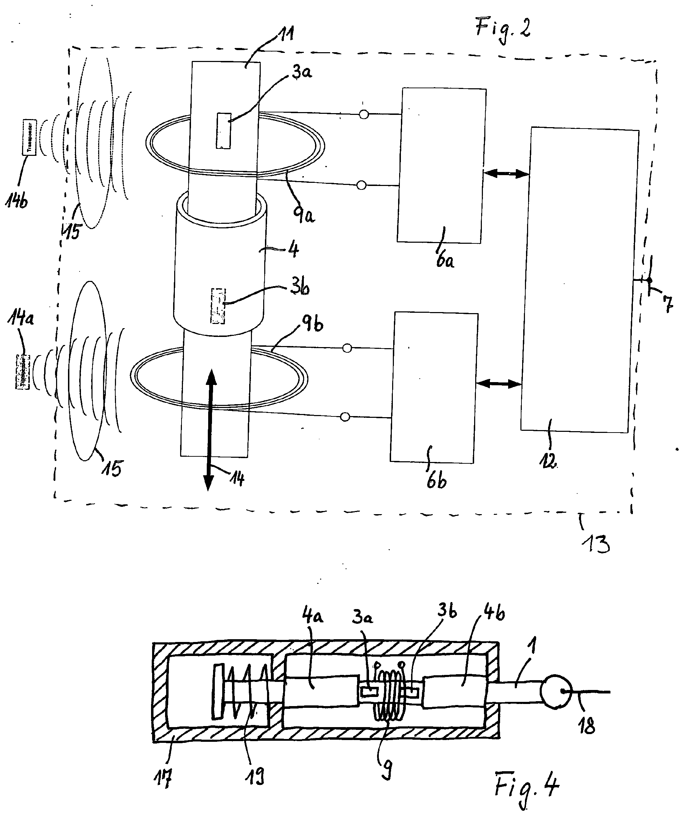

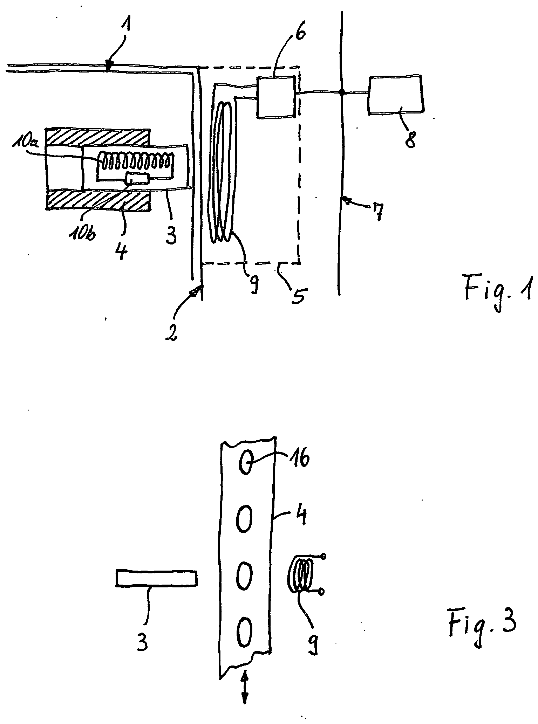

Fig. 4 zeigt schematisch ein viertes Ausführungsbeispiel einer Einrichtung zum Feststellen der Stellung eines Teils gegenüber einem anderen in Form eines Seilzugschalters. Der in Fig. 1 dargestellte Positionsschalter zum Feststellen der Schließstellung eines verschließenden Teils 1 in Form einer Schiebe- oder Schwenktür oder Klappe od. dgl. gegenüber einem verschließbaren Teil 2 in Form einer Türöffnung oder Zugangsöffnung in einer Maschinenverkleidung, Maschinenumzäunung od. dgl. umfaßt einen am verschließenden Teil 1 angebrachten Transponder 3 mit einer Abschirmung 4 sowie einen ortsfest am verschließbaren Teil 2 angebrachten Sendeempfänger 5 mit einer Steuerlogik 6, die über eine direkte drahtgebundene oder drahtlose Verbindung oder über einen Bus 7, beispielsweise einen Zweidrahtbus für die Spannungsversorgung und die Signalübertragung, mit einer Maschinensteuerung 8 zum Steuern der Einschaltbarkeit und des Abschaltens einer Maschine mit Gefahrenpotential abhängig von der Schließstellung des verschließenden Teils 1 angekoppelt ist.

Die über den Bus 7, einen separaten Anschluß, eine Batterie od.dgl. stromversorgte Steuerlogik 6 regt eine Spule 9 des Sendeempfängers 5 vorzugsweise periodisch zum Aussenden von Abfragesignalen an. Die Abfragesignale sind über einen Zeitraum ausgestrahlte elektromagnetische Wellen. Die elektromagnetischen Wellen können eine konstante oder variierende Frequenz aufweisen und/oder markiert sein, beispielsweise amplituden- oder frequenzmoduliert Informationsbits enthalten.

Die Abfragesignale werden von einer vorzugsweise senkrecht zur Spule 9 angeordneten Spule 10 im Transponder 3 empfangen. Zweckmäßigerweise liefert die empfangene Energie die Betriebsenergie für den Transponder 3, der jedoch auch über den Bus 7, einen separaten Anschluß, eine Batterie od.dgl. stromversorgt sein kann. Der Transponder 3 sendet in Reaktion auf die Abfragesignale zweckmäßigerweise über die selbe Spule 10 oder gegebenenfalls eine weitere Spule Antwortsignale aus. Diese können im einfachsten Fall eine bestimmte Frequenz aufweisen oder auf andere Weise markiert sein, insbesondere Informationsbits, z.B. eine eindeutige Transponderkennung, enthalten. Die Antwortsignale können zudem von den empfangenen Informationsbits abhängen, beispielsweise kann im Transponder 3 ein Schlüssel abgelegt sein, mit dem empfangene Informationsbits verschlüsselt und anschließend zurückgesendet werden.

Die Antwortsignale werden zweckmäßigerweise über die Spule 9 oder gegebenenfalls eine weitere Spule im Sendeempfänger 5 empfangen und können von der Steuerlogik 6 ausgewertet werden. Z.B. kann die Steuerlogik 6 die Frequenz der Antwortsignale oder deren Markierung auswerten und so feststellen, ob insbesondere ein bestimmter Transponder 3 vorhanden ist. In diesem Fall wird der geschlossene Schließzustand erkannt und der Maschinensteuerung 8 bereitgestellt, insbesondere an diese gesendet oder zum Abruf bereitgehalten. Wird kein oder nicht der richtige Transponder 3 festgestellt, wird der geöffnete Schließzustand erkannt und der Maschinensteuerung 8 bereitgestellt. In einer weiteren Ausführungsform kann die Auswertung der empfangenen Signale in der Maschinensteuerung 8 erfolgen, wobei die Steuerlogik 6 entfallen kann.

Der Schließstellungsgrenzabstand wird über die Abschirmung 4 eingestellt, die zwischen Stellungen mit verschieden starker Dämpfung der Signale, die sich zwischen dem Sendeempfänger 5 und dem Transponder 3 ausbreiten, insbesondere stufenlos verstellbar ist und zumindest in zwei Stellungen, vorzugsweise jedoch in allen oder mehreren Stellungen, relativ zum Transponder 3 feststellbar, insbesondere festschraubbar oder festklemmbar ist. Die Abschirmung 4 kann dabei wie dargestellt eine Metallhülse sein, in die der Transponder 3 einschiebbar ist und die eine Halterung für den Transponder 3 bildet. In der eingeschobenen Stellung überdeckt die Abschirmung 4 die Spule 10 vollständig, so daß eine größtmögliche Dämpfung erzielt wird. Der Schließstellungsgrenzabstand ist in dieser Stellung am kleinsten, d.h. der Transponder 3 muß sehr nahe am Sendeempfänger 5 sein, damit der Positionsschalter einen geschlossenen Schließzustand signalisiert. Ist der Transponder 3 nicht in die Abschirmung 4 eingeschoben, ist die Dämpfung am geringsten und der Schließstellungsgrenzabstand am größten, d.h. die geschlossene Schließstellung wird bereits bei großem Abstand zwischen Transponder 3 und Sendeempfänger 5 signalisiert. Ist der Transponder 3 nur teilweise in die Abschirmung 4 eingeschoben, liegt die Dämpfung und damit der Schließstellungsgrenzabstand zwischen den beiden Extremwerten.

Bei der Montage des Positionsschalters werden daher zunächst der Transponder 3 nebst Abschirmung 4 am verschließenden Teil 1 und der Sendeempfänger 5 am verschließbaren Teil 2, oder umgekehrt, in einem beliebigen Abstand montiert, z.B. der Transponder 3 benachbart zum Rand an einer Tür und der Sendeempfänger an einem Türrahmen, so daß Transponder 3 und Sendeempfänger 5 in geschlossenem Zustand der Tür benachbart zueinander sind. Der Transponder 3 kann zusammen mit der Abschirmung 4 auch von der Oberfläche der Tür vorstehen, beispielsweise in Form eines Stiftes oder als Teil einer mechanischen Zuhalteeinrichtung mit einer Öffnung für einen Riegel, wobei dann eine entsprechende Aussparung im Sendeempfänger 5 vorgesehen und sich insbesondere durch das Innere des Spule 9 erstrecken kann, in die in geschlossenem Zustand der Zugangsschutzeinrichtung zumindest ein Teil des Transponders 3 nebst Abschirmung 4 eingreift.

Anschließend wird der Schließstellungsgrenzabstand durch Verschieben der Abschirmung 4 in Bezug auf den Transponder 3 oder des Transponders 3 in Bezug auf die Abschirmung 4 so eingestellt, daß der geschlossene vom geöffneten Schließzustand der Zugangsschutzeinrichtung sicher feststellbar ist.

Die Abschirmung 4 kann anstelle einer Metallhülse auch als ein Metallblech oder ein Gitter oder eine andere Struktur ausgebildet sein, die in einer dämpfenden Stellung zumindest einen Teil der Spule 10 des Transponders 3 abdeckt. Die Abschirmung 4 kann zusätzlich oder alternativ auch am Sendeempfänger 5 vorgesehen sein.

In der Ausführungsform mit in das Innere der Spule 9 eingreifendem Transponder 3 kann die Abschirmung 4 eine in die Spule 9 einschiebbare Innenhülse sein, die gegebenenfalls eine axial variierende Dämpfungsleistung aufweist und hierzu beispielsweise an einem Ende dicker ist als am anderen.

Die Spulen 9, 10 sind senkrecht zueinander dargestellt, können jedoch auch parallel zueinander angeordnet oder gegeneinander geneigt sein.

Wenn man bei Fig. 1 annimmt, daß das Teil 1 senkrecht zur Papierebene zum Teil 2 beweglich ist, läßt sich durch die Positionierung der Abschirmung 4 der zulässige seitliche Versatz einstellen, bei dem sich der Transponder 3 noch im Lesebereich des Sendeempfängers 5 befindet. Dementsprechend läßt sich hierdurch auch für eine bestimmte Geschwindigkeit des Teils 1 relativ zum Teil 2 das Verweilzeitintervall des Transponders 3 im Lesebereich und damit die Erfassungszeit hiervon einstellen. Wenn das den Transponder 3 tragende Teil 1 gegenüber dem Teil 2 rotiert, läßt sich durch die Stellung der Abschirmung 4 die minimale und maximale Drehzahl einstellen, bei der der Transponder 3 noch erkannt wird. In diesem Fall läßt sich die Einrichtung zur sicheren Stillstandsüberwachung von gefahrbringenden, sich drehenden Teilen verwenden.

Bei der in Fig. 2 dargestellten Ausführungsform sind zwei Transponder 3a, 3b vorgesehen, die auf einem stationären oder beweglichen, etwa längsverschiebbaren Teil 11 mit Abstand zueinander angeordnet sind. Für jeden der beiden Transponder 3a, 3b gibt es eine diesbezüglich ortsfest angeordnete Spule 9a, 9b, die jeweils an einen separaten Sendeempfänger 6a, 6b angeschlossen sind, die ihrerseits mit einer Auswertelogik 12 verbunden sind. Das Teil 11 und eine Abschirmung 4, etwa eine Abschirmhülse, sind etwa zwischen zwei Endstellungen relativ zueinander beweglich, so daß die Abschirmung 4 in der jeweiligen Endstellung einen der beiden Transponder 3a, 3b gegenüber seiner Spule 9a bzw. 9b abschirmen kann.

Das Teil 11, etwa ein Riegel, kann beispielsweise an einem verschließenden Teil wie einer Tür entsprechend dem Pfeil 14 in seiner Längsrichtung beweglich sein, während die Abschirmung 4 an einem bezüglich des verschließenden Teils feststehenden verschließbaren Teil in Form einer Wandung, Umzäunung od.dgl. mit Tür- oder Zugangsöffnung in einer Maschinenverkleidung, Maschinenumzäunung od. dgl. angeordnet ist. Entsprechend der relativen Stellung der Abschirmung 4 zum jeweiligen Transponder 3a, 3b ist somit der geschlossene bzw. geöffnete Zustand des verschließenden Teils feststellbar. Wenn von keinem der Transponder 3a, 3b ein Echo mit ausreichendem Pegel kommt, ist das verschließende Teil offen. Wenn von beiden Transpondern 3a, 3b oder nur von einem bestimmten der beiden Transponder 3a, 3b ein Echo zurückkommt, ist die verschlossene Stellung noch nicht erreicht. Wenn dagegen nur der andere bestimmte der beiden Transponder 3a, 3b anspricht, befindet sich das verschließende Teil im verschlossenen Zustand zum verschließbaren Teil.

Es kann sich hierbei aber auch um ein gegenüber einem anderen Teil aus- oder verfahrbares Teil handeln, so daß festgestellt werden kann, ob der ein- oder ausgefahrene Zustand etwa des die Abschirmung tragenden Teils gegenüber dem die Transponder 3a, 3b tragenden Teil 11 vorliegt.

Gegebenenfalls können mehr als zwei mit Abstand zueinander angeordnete Transponder 3a, 3b mit zugehörigen Spulen und Sendeempfängern vorgesehen sein, um verschiedene Ausfahrzustände zu detektieren, die durch das Abschirmen eines der Transponder durch die Abschirmung bestimmt sind.

Das Teil 11 kann auch als Stößel eines berührungslosen Positionsschalters in dessen Gehäuse 13 verschiebbar gekoppelt mit einem gegenüber dem Gehäuse 13 beweglichen Teil ausgebildet sein.

Gegebenenfalls kann auch noch zu jeder der mindestens zwei Spulen 9a, 9b stationär angeordnet ein weiterer Transponder 14a, 14b vorgesehen sein, der von der jeweiligen Spule 9a, 9b ansprechbar ist, um so die Funktionsfähigkeit der Positionsüberwachungseinrichtung prüfen zu können.

Wenn mehrere Positionsschalter vorgesehen sind, kann das jeweilige Gehäuse 13 mit wenigstens einem Fenster 15 versehen sein, während an dem Teil, an dem das Gehäuse 13 befestigt ist, wenigstens ein zusätzlicher Transponder 14a, 14b angeordnet ist, der durch eine entsprechende Spule 9a, 9b permanent detektierbar ist, um eine entsprechende Adresse für den jeweiligen Positionsschalter zu liefern, um zwischen Signalen von an unterschiedlichen Orten befindlichen Positionsschaltern auf dem Bus 7 unterscheiden zu können. Bei Vorhandensein von jeweils einem Transponder 14a, 14b für jeweils eine Spule 9a, 9b ist die vorstehend erwähnte Möglichkeit der Prüfung auf Funktionsfähigkeit gegeben.

Bei dem in Fig. 3 dargestellten Ausführungsbeispiel besteht die Abschirmung 4 aus einem Blechstreifen mit zueinander regelmäßig beabstandeten Löchern 16 und ist an dem sich bewegenden Teil 1 befestigt, während der Transponder 3 und der Sendeempfänger 5 gegenüber dem Teil 1 und damit gegenüber der Abschirmung 4 feststehend sind. Hierdurch ergibt sich eine Art elektromagnetischer "Lichtschranke", bei der beispielsweise die (Dreh-)Geschwindigkeitdes Teils 1 gegenüber dem Teil 2 entsprechend dem zeitlichen Abstand des Erfassens des Transponders 3 zwischen den durch die Abschirmung 4 bewirkten Unterbrechungen bestimmbar ist.

Bei dem in Fig. 4 dargestellten Ausführungsbeispiel eines Seilzugschalters ist das stößelförmige Teil 1, das zwei in Längsrichtung des Teils 1 zueinander beabstandete Transponder 3a, 3b trägt, in einem Gehäuse 17 geführt, ragt aus diesem heraus und an seinem freien Ende mit einem Seilzug 18 verbunden, der normalerweise gespannt ist. Zwei beispielsweise hülsenförmige Abschirmungen 4a, 4b sind vorgesehen, die die Transponder 3a, 3b gegenüber der Spule 9 des Sendeempfängers 5 abschirmen können. Das stößelförmige Teil 1 ist über eine Feder 19 gegenüber dem Gehäuse 17 in Richtung entgegen dem Zug des Seilzugs 18 vorgespannt. Der Seilzug 18 hält das Teil 1 in der Ausgangsstellung in einer Mittelstellung der Transponder 3a, 3b, so daß sich beide im Lesebereich der Spule 9 befinden. Wird nun der Seilzug 18 betätigt, d.h. daran gezogen, gelangt der Transponder 3b in den Bereich der Abschirmung 4b und damit aus dem Lesebereich der Spule 9. Dies löst über die Spule 9 ein entsprechendes Signal aus. Reißt der Seilzug 18, drückt dagegen die Feder 19 das Teil 1 in eine Stellung, in der der Transponder 3a in den Bereich seiner benachbarten Abschirmung 4a und damit aus dem Lesebereich der Spule 9 gelangt. Infolge der Transponderkennung ist somit der Ausfall des Seilzugschalters feststellbar und ein entsprechendes Störsignal od.dgl. erzeugbar.

Es lassen sich auch Transponder 3 verwenden, an denen elektronische (digitale oder analoge) Geber angeschlossen werden können. Der Transponder 3 ist dann in der Lage, Schaltzustände und Meßwerte im Antwortsignal zu übertragen. Dies kann angewendet werden, wenn Informationen und Meßwerte von rotierenden Teilen 1 auf feststehende Teile 2 übertragen werden sollen.

Anstelle einer metallischen Abschirmung 4 kann beispielsweise auch eine solche aus einem ferromagnetischen Kunststoff verwendet werden.

Die Abschirmung 4 braucht nicht hülsenförmig zu sein, sondern kann auch irgendeine andere Geometrie aufweisen, z.B. platten- oder kugelflächenförmig sein.

## Patentansprüche

1. Positionsüberwachungseinrichtung zum Feststellen der Stellung eines ersten Teils (2 oder 1) gegenüber einem zweiten Teil (1 oder 2), mit einem Sendeempfänger (5) am ersten Teil (2 oder 1) zum Aussenden eines Abfragesignals und zum Empfangen eines in Reaktion auf das Abfragesignal von einem Transponder (3) aussendbaren Antwortsignals, wobei eine Signale zwischen dem Transponder (3) und dem Sendeempfänger (5) dämpfende Abschirmung (4) vorgesehen ist und zwei der drei Teile Sendeempfänger (5), Abschirmung (4) und Transponder (3) relativ zueinander beweglich sind, wobei die Abschirmung (4) bezüglich des den Transponder (3) tragenden zweiten Teils (1 oder 2) zwischen Stellungen mit jeweils unterschiedlicher Abschirmstärke relativ verstellbar ist, **dadurch gekennzeichnet, daß** über die Abschirmung (4) ein Stellungsgrenzabstand zwischen dem ersten und zweiten Teil (1, 2) einstellbar ist.

2. Einrichtung nach Anspruch 1, **dadurch gekennzeichnet, daß** die Abschirmung (4) bezüglich des Transponders (3) beweglich ist.

3. Einrichtung nach Anspruch 1 oder 2, **dadurch gekennzeichnet, daß** über die Abschirmung (4) ein zulässiger Versatz zwischen den beiden Teilen (1, 2) einstellbar ist.

4. Einrichtung nach einem der Ansprüche 1 bis 3, **dadurch gekennzeichnet, daß** über die Abschirmung (4) ein Verweilzeitintervall des Transponders (3) im Lesebereich des Sendeempfängers (5) einstellbar ist.

5. Einrichtung nach einem der Ansprüche 1 bis 4, **dadurch gekennzeichnet, daß** die Abschirmung (4) in einer Stellung mit einer höheren Abschirmstärke wenigstens einen größeren Abschnitt des Transponders (3) oder des Sendeempfängers (5) abschirmt und einen kürzeren Stellungsgrenzabstand festlegt als in einer Stellung mit einer niedrigeren Abschirmstärke.

6. Einrichtung nach einem der Ansprüche 1 bis 5, **dadurch gekennzeichnet, daß** die Abschirmung (4) bezüglich des den Transponder (3) bzw. den Sendeempfänger (5) tragenden Teils (1 oder 2) in wenigstens zwei Stellungen feststellbar ist.

7. Einrichtung nach Anspruch 6, **dadurch gekennzeichnet, daß** die Abschirmung (4) bezüglich des den Transponder (3) tragenden zweiten Teils (1 oder 2) zwischen zwei Endstellungen relativ beweglich ist.

8. Einrichtung nach einem der Ansprüche 1 bis 7, **dadurch gekennzeichnet, daß** sie als berührungsloser Positionsschalter mit einem Gehäuse (13) ausgebildet ist, das das den Transponder (3) tragende zweite Teil (1 oder 2) und die Abschirmung (4) relativ zueinander beweglich aufnimmt.

9. Einrichtung nach einem der Ansprüche 1 bis 8, **dadurch gekennzeichnet, daß** das den Transponder (3) tragende zweite Teil (2 oder 1) ein Stößel ist.

10. Einrichtung nach einem der Ansprüche 1 bis 9, **dadurch gekennzeichnet, daß** die Abschirmung (4) eine Abschirmhülse ist, die relativ zum Transponder (3) verschiebbar ist.

11. Einrichtung nach einem der Ansprüche 1 bis 10, **dadurch gekennzeichnet, daß** der Sendeempfänger (5) eine Öffnung für den Transponder (3) aufweist.

12. Einrichtung nach einem der Ansprüche 1 bis 11, **dadurch gekennzeichnet, daß** mindestens ein weiterer Transponder (3a, 3b) auf dem den Transponder (3) tragenden zweiten Teil (1 oder 2) vorgesehen ist, und der Transponder (3) und der mindestens eine weitere Transponder (3a, 3b) über wenigstens einen eine Auswertelogik (12) angeschlossenen Sendeempfänger (6, 6a, 6b) auslesbar sind.

13. Einrichtung nach Anspruch 12, **dadurch gekennzeichnet, daß** mindestens ein zusätzlicher stationärer Transponder (14a, 14b) zur Identifizierung der Einrichtung vorgesehen ist.

14. Einrichtung nach Anspruch 12 oder 13, **dadurch gekennzeichnet, daß** für jeden Sendeempfänger (6a, 6b) ein zusätzlicher stationärer Transponder (14a, 14b) vorgesehen ist.

15. Einrichtung nach Anspruch 12, **dadurch gekennzeichnet, daß** der Transponder (3) und der mindestens eine weitere Transponder (3a, 3b) auf dem zweiten Teil (1 oder 2) angeordnet sind, die in einer Mittelposition von dem Sendeempfänger (6, 6a, 6b) auslesbar und mit dem zweiten Teil (1 oder 2) in eine bezüglich der Mittelposition zur einen oder anderen Seite verschobenen Position bringbar sind, in der jeweils einer der mindestens zwei Transponder (3a, 3b) durch eine Abschirmung (4a, 4b) abgeschirmt ist.

## Claims

1. A position monitoring device for establishing the position of a first part (2 or 1) with respect to a second part (1 or 2), having a transceiver (5) at the first part (2 or 1) for emitting an interrogation signal and for receiving a response signal that can be emitted in reaction to the interrogation signal by a transponder (3), wherein a screen (4) that attenuates signals between the transponder (3) and the transceiver (5) is provided and two members of the group consisting of the transceiver (5), the screen (4) and the transponder (3) being movable relative to one another, wherein the screen (4) is positionable in a relative manner with regard to the second part (1 or 2) carrying the transponder (3) between positions having a different screening strength, **characterized in that** via the screen (4) a limiting distance between the first and second part (1, 2) is adjustable.

2. The device according to Claim 1, **characterized in that** the screen (4) is movable relatively to the transponder (3).

3. The device according to Claim 1 or 2, **characterized in that** via the screen (4) a limiting disalignment between the both parts (1, 2) is adjustable.

4. The device according to one of Claims 1 to 3, **characterized in that** via the screen (4) a detection time interval of the transponder (3) within the detection area of the transceiver (5) is adjustable.

5. The device according to one of Claims 1 to 4, **characterized in that** the screen (4) in a position with a higher screening strength screens at least one larger section of the transponder (3) or of the transceiver (5) and defines a shorter position limiting distance than in a position with a lower screening strength.

6. The device according to one of Claims 1 to 5, **characterized in that** the screen (4) can be fixed with regard to the part (1 or 2) carrying the transponder (3) or the transceiver (5) in at least two positions.

7. The device according to Claim 6, **characterized in that** the screen (4) is movable in a relative manner with regard to the second part (1 or 2) carrying the transponder (3) between two end positions.

8. The device according to one of Claims 1 to 7, **characterized in that** it is formed as a contactless position switch with a housing (13) that receives the second part (1 or 2) carrying the transponder (3) and the screen (4) in a movable manner relative to one another.

9. The device according to one of Claims 1 to 8, **characterized in that** the transponder (3)-carrying second part (2 or 1) is a plunger.

10. The device according to one of Claims 1 to 9, **characterized in that** the screen (4) is a sleeve which is relatively movable to the transponder (3).

11. The device according to one of Claims 1 to 10, **characterized in that** the transceiver (5) has an opening for the transponder (3).

12. The device according to one of Claims 1 to 11, **characterized in that** provision is made of at least one additional transponder (3a, 3b) on the transponder (3)-carrying second part (1 or 2) and that the transponder (3) and the at least one additional transponder (3a, 3b) are detectable via at least one transceiver (6, 6a, 6b) connected with an evaluation logic (12).

13. The device according to Claim 12, **characterized in that** at least one additional stationary transponder (14a, 14b) is provided for identifying the device.

14. The device according to Claim 12 or 13, **characterized in that** provision is made of an additional stationary transponder (14a, 14b) for each transceiver (6a, 6b).

15. The device according to Claim 12, **characterized in that** the transponder (3) and the at least one additional transponder (3a, 3b) are arranged on the second part (1 or 2) being detectable in a middle position by the transceiver (6, 6a, 6b) and being transportable by the second part (1 or 2) in a position shifted to the one or other side of the middle position in which shifted positions one of the at least two transponders (3a, 3b) is screened by a screen (4a, 4b).

## Revendications

1. Dispositif de surveillance de position servant à constater la position d'un premier élément (2 ou 1) par rapport à un deuxième élément (1 ou 2), avec un émetteur-récepteur (5) au niveau du premier élément (2 ou 1) servant à envoyer un signal de demande et servant à recevoir un signal de réponse pouvant être envoyé en réaction au signal de demande par un transpondeur (3), dans lequel un blindage de protection (4) atténuant des signaux entre le transpondeur (3) et l'émetteur-récepteur (5) est prévu et deux des trois éléments que sont l'émetteur-récepteur (5), le blindage de protection (4) et le transpondeur (3) sont mobiles l'un par rapport à l'autre, dans lequel le blindage de protection (4) peut être ajusté de manière relative par rapport au deuxième élément (1 ou 2) supportant le transpondeur (3) entre des positions avec une intensité de protection respectivement différente, **caractérisé en ce qu'**une distance limite de position entre le premier et le deuxième élément (1, 2) peut être réglée par l'intermédiaire du blindage de protection (4).

2. Dispositif selon la revendication 1, **caractérisé en ce que** le blindage de protection (4) est mobile par rapport au transpondeur (3).

3. Dispositif selon la revendication 1 ou 2, **caractérisé en ce qu'**un décalage admissible entre les deux éléments (1, 2) peut être réglé par l'intermédiaire du blindage de protection (4).

4. Dispositif selon l'une quelconque des revendications 1 à 3, **caractérisé en ce qu'**un intervalle de temps de séjour du transpondeur (3) dans la zone de lecture de l'émetteur-récepteur (5) peut être réglé par l'intermédiaire du blindage de protection (4).

5. Dispositif selon l'une quelconque des revendications 1 à 4, **caractérisé en ce que** le blindage de protection (4) protège, dans une position, avec une intensité de protection plus élevée, au moins une plus grande section du transpondeur (3) ou de l'émetteur-récepteur (5) et fixe une distance limite de position la plus courte que dans une position présentant une intensité de protection plus faible.

6. Dispositif selon l'une quelconque des revendications 1 à 5, **caractérisé en ce que** le blindage de protection (4) peut être constaté dans au moins deux positions par rapport à l'élément (1 ou 2) supportant le transpondeur (3) ou l'émetteur-récepteur (5).

7. Dispositif selon la revendication 6, **caractérisé en ce que** le blindage de protection (4) est mobile de manière relative entre deux positions finales par rapport au deuxième élément (1 ou 2) supportant le transpondeur (3).

8. Dispositif selon l'une quelconque des revendications 1 à 7, **caractérisé en ce qu'**il est réalisé sous la forme d'un commutateur de position sans contact avec un boîtier (13), qui accueille le deuxième élément (1 ou 2) supportant le transpondeur (3) et le blindage de protection (4) de manière mobile l'un par rapport à l'autre.

9. Dispositif selon l'une quelconque des revendications 1 à 8, **caractérisé en ce que** le deuxième élément (2 ou 1) supportant le transpondeur (3) est un poussoir.

10. Dispositif selon l'une quelconque des revendications 1 à 9, **caractérisé en ce que** le blindage de protection (4) est une douille de protection, qui peut être coulissée par rapport au transpondeur (3).

11. Dispositif selon l'une quelconque des revendications 1 à 10, **caractérisé en ce que** l'émetteur-récepteur (5) présente une ouverture pour le transpondeur (3).

12. Dispositif selon l'une quelconque des revendications 1 à 11, **caractérisé en ce qu'**au moins un autre transpondeur (3a, 3b) est prévu sur le deuxième élément (1 ou 2) supportant le transpondeur (3), et le transpondeur (3) et l'au moins un autre transpondeur (3a, 3b) peuvent être lus par l'intermédiaire d'au moins un émetteur-récepteur (6, 6a, 6b) raccordé à une logique d'évaluation (12).

13. Dispositif selon la revendication 12, **caractérisé en ce qu'**au moins un transpondeur (14a, 14b) stationnaire supplémentaire est prévu aux fins de l'identification du dispositif.

14. Dispositif selon la revendication 12 ou 13, **caractérisé en ce qu'**un transpondeur (14a, 14b) stationnaire supplémentaire est prévu pour chaque émetteur-récepteur (6a, 6b).

15. Dispositif selon la revendication 12, **caractérisé en ce que** le transpondeur (3) et l'au moins un autre transpondeur (3a, 3b) sont disposés sur le deuxième élément (1 ou 2), lesquels peuvent être lus dans une position centrale par l'émetteur-récepteur (6, 6a, 6b) et qui peuvent être amenés avec le deuxième élément (1 ou 2), dans une position coulissée, par rapport à la position centrale, en direction d'un ou de l'autre côté, dans laquelle respectivement un des au moins deux transpondeurs (3a, 3b) est protégé par un blindage de protection (4a, 4b).
